# EUROPEAN PATENT SPECIFICATION

(11) **EP 2 661 794 B1**
(45) Date of publication and mention of the grant of the patent: **19.02.2020**
(21) Application number: 11855058.1
(22) Date of filing: 04.01.2011
(51) Int. Cl.: H01S 3/067, H01S 3/102, H01S 3/094, H01S 3/0941, H01S 3/16, H01S 3/10, H01S 5/06, H01S 3/13

(54) **METHOD FOR STABILIZING OPTICAL OUTPUT POWER OF FIBER LASER**
VERFAHREN ZUR STABILISIERUNG DER OPTISCHEN AUSGANGSLEISTUNG EINES FASERLASERS
PROCÉDÉ PERMETTANT DE STABILISER LA PUISSANCE DE SORTIE OPTIQUE D'UN LASER À FIBRE

(43) Date of publication of application: 13.11.2013
(73) Proprietor: IPG Photonics Corporation, Oxford, Massachusetts 01540 (US)
(72) Inventor: GAPONTSEV, Valentin, Oxford, MA 01540 (US); SHCHERBINA, Fedor, 57074 Siegen (DE); SHUMILIN, Vasili, 57250 Netphen (DE); MASHKIN, Andrei, 57259 Netphen (DE)
(74) Representative: Kohlmann, Kai
(86) International application number: PCT/US2011/020097
(87) International publication number: WO 2012/093993

(56) References cited:
- EP-A1- 2 385 593
- EP-A2- 1 317 037
- WO-A2-2006/007756
- JP-A- 2007 535 159
- US-A1- 2003 142 395
- US-A1- 2009 196 320
- US-B1- 6 246 511
- US-B1- 6 327 277
- US-B1- 6 373 048

## Description

### FIELD OF THE DISCLOSURE

The present invention relates to lasers. More specifically, the disclosure relates to a method for stabilizing the optical output power of a fiber laser within the desired temperature diapason.

### BACKGROUND OF THE INVENTION

### Prior Art

Wavelength, elevated temperatures, output power, absorption spectrum are just a few important parameters always considered in the laser design. The parameters are in close relationship with one another; selecting anyone of them necessarily affects the others. For example, in a laser and amplifier based on active fibers and configured with laser diodes as a pump, if a pump radiation is emitted at the desired wavelength, it will be effectively absorbed in the gain medium of active fibers. The higher absorption, the higher the efficiency of the entire system.

Typical multimode diodes without a wavelength stabilization mechanism are temperature sensitive devices with a wavelength of radiation drifting towards longer wavelengths with the rising temperature The temperature rise is accompanied by the following processes: 1. the drift of the pump emission wavelength towards longer frequencies leading to the absorption change which, in turn, conditions 2. the pump power drop.

There are different approaches aiming at minimizing effects of elevated temperatures. One approach includes monitoring the output power of the fiber laser or amplifier and modulating diode current by means of a feedback circuitry for maintaining the desired output power. Another approach is based on monitoring the pump's output radiation and actively controlling the temperature. This approach requires the use of thermo-electric coolers which may render laser systems cost-ineffective.

Still a further approach is represented, for example, by US 2003/0142395 ("the US '395") disclosing a method of a coolerless optimization of pump light for pumping an Er or Er-Yb fiber amplifier. In particular, this reference teaches selecting the wavelength drift within such an operating temperature diapason that the absorption characteristics of the optical fiber amplifier remain substantially unchanged over the operating diapason. This approach is rather limited.

A need, therefore, exists for a method of stabilizing the output power of a fiber laser or oscillator without the use of costly temperature controlling configurations.

A further need exists for a fiber laser system realizing this method.

US 2003/142395 A1, EP 1 317 037 A2, and EP 2 385 593 A1 each discloses an optical fiber amplifier with a laser diode pump configured to operate over a predetermined temperature range with known wavelength drift and for which active cooling is not required. EP 2 385 593 A1 relates to prior art relevant to the question of novelty only, pursuant to Article 54(3) EPC.

### SUMMARY OF THE INVENTION

The disclosure takes into consideration the relationship between two mechanisms observed during the operation of a fiber laser system including laser diodes or a pump and at least a fiber oscillator or fiber laser. The first mechanism includes the pump output power drop with the pump temperature rising from an initial temperature T₁ to a higher one T₂. The other mechanism accounts for a pump light absorption being a function of variable emission pump wavelength. The power drop of the pump's output causes the laser's output to lower, whereas the increased absorption has the opposite effect - the laser's output power increases. Thus, the disclosed method takes into account the dependency of both pump power drop and lasing threshold change from temperature variations in such a way as to provide for a substantially stable opto-electrical efficiency of fiber laser system. In accordance with the present invention there is provided a method as defined in claim 1 and a fiber laser system as defined in claim 4. Embodiments of the invention are set out in the dependent claims.

### BRIEF DESCRIPTION OF THE DRAWINGS

The details of the disclosed method and fiber laser system will be discussed hereinbelow in conjunction with the accompanying drawings, in which:
FIG. 1 is a schematic of fiber laser system configured according to the disclosure.
FIG. 2 is an exemplary schematic of the fiber laser of the disclosed system.
FIG. 3 is the absorption/emission spectra illustrating the disclosed method.
FIG. 4A and 4B illustrate a pump light wavelength drift as the temperature changes from 20°C of FIG. 4A to 36°C of FIG. 4B.

### SPECIFIC DESCRIPTION

Reference will now be made in detail to the disclosed system. The drawings are in simplified form and are far from precise scale. The word "couple" and similar terms do not necessarily denote direct and immediate connections, but also include connections through intermediate elements or devices.

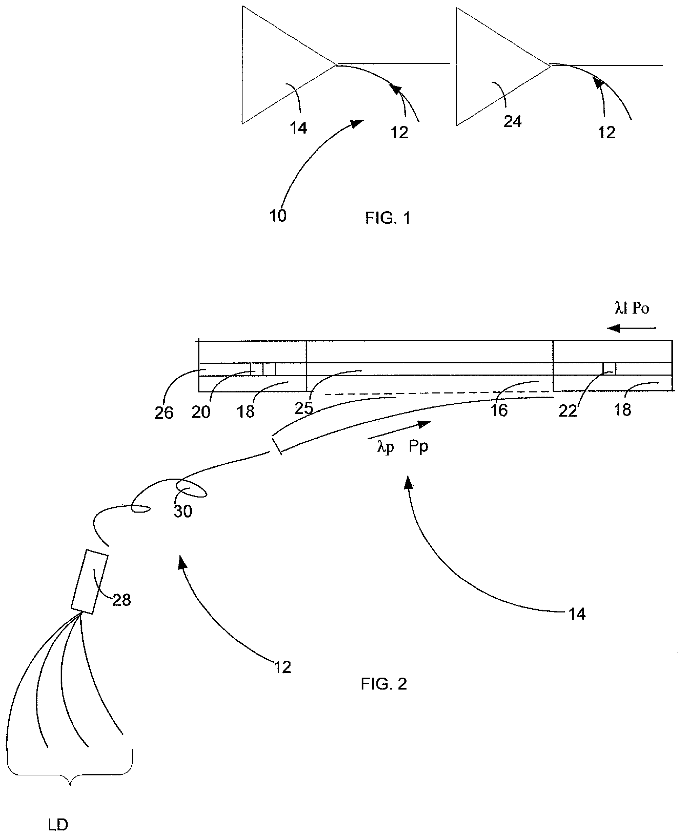

FIG. 1 illustrates a high power fiber laser system 10 configured with one or multiple gain blocks which necessarily include an oscillator 14 and possibly multiple fiber amplifiers 24. The gain blocks 14, 24 each are provided with a pump unit 12 generating pump radiation at a pump wavelength. Preferably, but not necessarily, fiber laser system 10 is a high power laser system radiating a system output at a system wavelength and in a substantially fundamental mode.

Referring to FIG. 2, gain blocks 14 of system 10 preferably has the configuration disclosed in US Patents 5,422,897 and 5,774,484. In particular, oscillator 14 is configured with a multimode (MM) fiber 16 fusion spliced between single mode (SM) fibers 18, and reflectors, such as fiber gratings 20 and 22, which define an optical cavity. The MM fiber 16 supports multiple modes at a wavelength different from the lasing wavelength but is configured to guide substantially only a fundamental mode at the lasing wavelength. The cores 25 and 26 of respective MM active and SM passive fibers 16, 18 are configured so that the fundamental mode spot size of MM fiber 16 substantially matches that of SM fiber 18. Such a configuration amounts to efficient coupling of the fundamental modes of the respective fibers at the splice, which minimizes the possibility of high mode excitation. Depending on the desired output power of laser system 10, the illustrated schematic may additionally have one or more fiber amplifiers 24 each configured similar to oscillator 14 only without the gratings.

The pump or optical source 12 is a laser diode array (LDA) emitting pump light at the pump wavelength λp different from the lasing wavelength λl. The laser diodes LD of the array are arranged so as to achieve optimum coupling of pump power into multimode fiber 16. As illustrated, system 10 is provided with a side-pumping scheme, but as one of ordinary skill in the laser arts realizes, and end-pumping technique can be used as well. A coupling efficiency of pump light, which is delivered by a MM passive fiber 30, into fiber 16 and the desired power output of laser 14 provide a sufficient data for the determination of the pump's power Pp. The laser diodes LD of pump 12 are typically combined into a module 28 disclosed in US Patents 7,764,723 and 7,773,655.

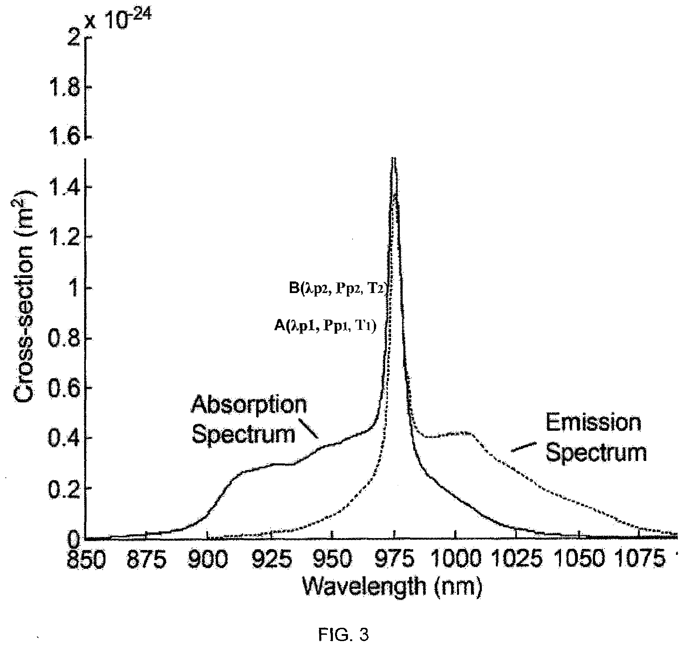

FIG. 3 illustrates the desired absorption and emission cross-section spectra of the Yb3+-doped phosphate active fiber of gain blocks 14 and 24 of FIGs. 1 and 2. As known, the gain medium is powered by pump light. Only absorbed pump light can be useful. Thus, the efficient absorption of pump light is essential for the opto-electrical power efficiency of the fiber laser and/or laser amplifier generally referred to as a fiber laser system.

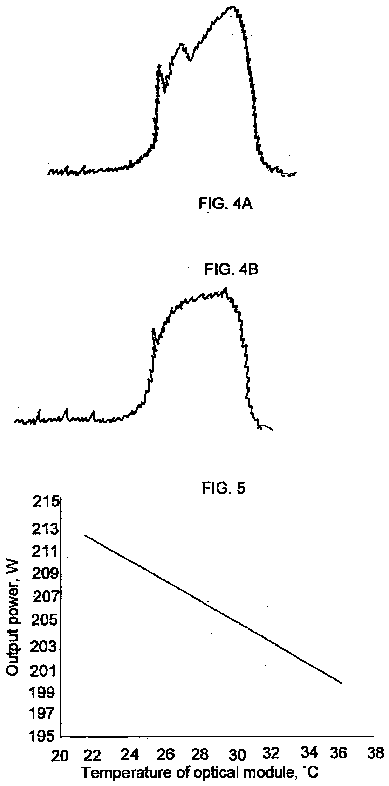

FIGs. 4A and 4B illustrate a typical pump light wavelength drift as the temperature changes from 20°C of FIG. 4A to 36°C of FIG. 4B. As known and illustrated, the pump wavelength tends to drift to longer wavelengths when a pump is in operation due to rising pump temperatures. The closer the pump wavelength to the center wavelength of a laser emission, the higher the absorption and the higher the output power of laser system 10. Accordingly, the pump wavelength at the highest temperature maybe either shorter, equal or slightly longer than the peak wavelength at which the gain medium absorbs pump light.

FIG. 5 illustrates the tendency in accordance with which the pump output power drops as the temperatures climb higher. Typically, the rate at which the pump power changes is about .46% per degree. As illustrated, the temperature's drift from about 24°C to about 36°C leads to about a 5.5% pump power drop.

Both of the above-discussed mechanisms thus factor in the efficiency of laser system 10. The latter can be improved by balancing the enhanced absorption and pump power decrease as the pump temperature rises within a certain range along the rising slope of the absorption spectra. Many industrial fiber laser applications are associated with sufficiently uniform system and environmental conditions. As a consequence, the configuration of laser diodes and active fibers should be such that the increased absorption would compensate for the diminished pump power within the desired pump temperature range. Such a configuration would translate into a stable output power of system 10 and its high efficiency without the necessity of monitoring the output of the gain block and without the modulation of the electrical signal at the input of the pump.

Returning to FIG. 3, the point A on the spectrum corresponds to a pump light radiated at a first pump wavelength λp₁ with an output power Pp₁ and at first temperature T₁. As can be seen, the absorption of the pump light at the first wavelength is far from being effective. Turning to point B on the spectrum, as the temperature rises from T₁ to T₂, the pump light is radiated at a wavelength λp₂ longer than the λp₁ and associated with a substantially higher absorption. However, the pump power Pp₂ at temperature T₂ is lower than power Pp₁. Since the output system power Po ∼ f(ΔA/ΔT; ΔPp/ΔT) the difference between absorption value ΔA and difference between pump power ΔPp within the substantially uniform temperature diapason ΔT=T₂-T₁ is selected so that the system power Po remains substantially stabilized. The process of manufacturing laser diodes with substantially stable wavelengths at respective known temperatures is relatively easy and can be practiced in conjunction with any off the shelf active fibers.

In a particularly advantageous configuration, the disclosed pump is configured to emit light at pump wavelength λp₂ substantially coinciding with a peak wavelength of the absorption spectra. However, the disclosed fiber laser system with a stable output power, which is attained without any active control of the latter, may operate anywhere along the leading slope including the peak and even a stretch of the trailing slope next to the peak.

The active fiber may have the gain medium including rare earth ions, such as Nd³⁺, Yb³⁺, Er³⁺, Tm³⁺ and others which all have respective well defined emission spectra. Preferably, but not necessarily, active fibers each have a double clad LMA configuration. The laser diodes may radiate pump light in different wavelength ranges. Given only as an example, laser diodes each may have a MM configuration radiating pump light in a 9xx nm and/or 8xx nm wavelength range, and a SM configuration emitting pump light at about 1064 nm. Typically, laser diodes for high power fiber lasers are arranged in modules. The examples of the latter may be found in US Patents 7,773,655 and 7,764,723.

In summary, the disclosed method includes specifying an output power of fiber laser system at a room temperature, such as about 20° C. As an active fiber being drawn, the absorption of pump light at a predetermined pump wavelength is determined as a function of the fiber's length. In other words, for every active fiber, the absorption of pump light per fiber length unit is determined for the predetermined wavelength. Then a fiber block, as shown for example in FIG. 2, is configured from the length of active fiber characterized by the specified absorption rate at the predetermined wavelength. Accordingly, the absorption change is also known with the wavelength drift. As a result, the stability of the fiber laser system output substantially improves while the temperature keeps rising.

Having described the embodiments of the present invention with reference to the drawings, it is to be understood that the invention is not limited to these precise embodiments, and that various changes, and adaptations may be effected by one skilled in the art without departing from the scope of the invention as defined in the appended claims.

## Claims

1. A method of stabilizing an output power of a fiber laser system (10) comprising coupling a pump light from a pump including one or more laser diodes (12) in an active fiber (16) of a fiber laser oscillator (14) between a relatively low first temperature (T₁) and relatively high second temperature (T₂), thereby decreasing a pump power during the temperature rise while increasing absorption of the pump light in a gain medium of the active fiber as the pump wavelength increases during the temperature rise, the increasing absorption compensating for the decreasing pump power so that the output power and electro-optical efficiency of the laser system remains substantially uniform over the entire temperature range from the first temperature to the second temperature, wherein the laser diode(s) are configured such that the longer pump light wavelength (λₚ₂) at the relatively high second temperature(T₂) is closer to a peak wavelength of the gain medium absorption spectrum at which the gain medium absorbs the pump light than the shorter wavelength (λₚ₁) of pump light at the relatively low first temperature (T₁) and wherein the wavelength (λₚ₂) of the pump light at the second temperature (T₂) substantially coincides with or is longer than the peak wavelength, wherein the length of the active fiber (16) is selected such that the absorption of the pump light at a predetermined pump light wavelength in the gain medium of the active fiber (16) has a desired value determined as a function of the active fiber's length.

2. The method of claim 2, wherein the pump light wavelength is selected from the group consisting of 8xx, 9xx and 106x nm.

3. The method of claim 1, wherein the gain medium includes ions selected from the group consisting of Yb, Er, Tm, and Nd and a combination thereof.

4. A fiber laser system comprising:
at least one gain block (14) provided with an active fiber (16) of a fiber laser oscillator (14); and
a pump suitable for radiating a pump light coupled in a gain medium of the active fiber (16) as a temperature rises from a low temperature (T₁) to a high temperature (T₂),
wherein the pump is configured with at least one or more laser diodes (12) each radiating the pump light at the low temperature (T₁) at a first pump wavelength (λₚ₁) shorter than a second pump wavelength (λₚ₂) at the high temperature (T₂),
wherein the gain medium of the active fiber (16) has an absorption spectrum with a peak wavelength, the wavelength of the pump light emitted at the second pump wavelength (λₚ₂) substantially coincides with the peak wavelength or is selected to be longer than the peak wavelength and is closer to the peak wavelength than the first pump wavelength,
wherein the length of the active fiber (16) is selected such that the absorption of the pump light at a predetermined pump light wavelength in the gain medium of the active fiber (16) has a desired value determined as a function of the active fiber's length so that an output power and electro-optical efficiency of the fiber laser
system remains substantially uniform over the entire temperature range from the low temperature to the high temperature, while a pump output
power decreases during the temperature rise and absorption of the pump light in the gain medium increases during the temperature rise, the increasing absorption compensating for the decreasing pump power.

5. The system of claim 4, wherein the pump outputs pump light at a wavelength selected from the group consisting of a 8xx nm range, 9xx nm range and 106x nm range.

6. The system of claim 4, wherein the gain medium includes rare earth ions selected from the group consisting of Yb, Er, Tm and Nd ions and a combination thereof.

7. The system of claim 4, wherein the gain block further includes two passive fibers directly fused to respective opposite ends of the active fiber.

8. The system of claim 7 further comprising at least one additional gain block and an additional pump which is configured substantially identically to respective one gain block and pump, the one and additional gain blocks having respective laser and fiber amplifier configurations operating between the low and high temperatures (T₁, T₂).

9. The system of claim 7, wherein the active and passive fibers of each gain block are provided with respective cores which are configured to support respective single modes having substantially a uniform field diameter.

10. The system of claim 9, wherein the active fiber is a MM fiber configured to support substantially the single mode in a wavelength range of the output between the low and high temperatures range.

## Patentansprüche

1. Verfahren zur Stabilisierung einer Ausgangsleistung eines Faserlasersystems (10), umfassend Koppeln eines Pumpenlichts von einer Pumpe, die eine oder mehrere Laserdioden (12) beinhaltet, in eine aktive Faser (16) eines Faserlaseroszillators (14) zwischen einer relativ niedrigen ersten Temperatur (T₁) und relativ hohen zweiten Temperatur (T₂), wodurch eine Pumpenleistung während des Temperaturanstiegs verringert wird, während Absorption des Pumpenlichts in einem Gain-Medium der aktiven Faser erhöht wird, wenn die Pumpenwellenlänge während des Temperaturanstiegs zunimmt, wobei die zunehmende Absorption die abnehmende Pumpenleistung kompensiert, sodass die Ausgangsleistung und elektrooptische Effizienz des Lasersystems im Wesentlichen über den gesamten Temperaturbereich von der ersten Temperatur zur zweiten Temperatur einheitlich bleibt,
wobei die Laserdiode(n) so konfiguriert ist (sind), dass die längere Pumpenlichtwellenlänge (λₚ₂) bei der relativ hohen zweiten Temperatur (T₂) näher bei einer Spitzenwellenlänge des Gain-Medienabsorptionsspektrums ist, bei dem das Gain-Medium das Pumpenlicht absorbiert, als die kürzere Wellenlänge (λₚ₁) von Pumpenlicht bei der relativ niedrigen ersten Temperatur (T₁) und wobei die Wellenlänge (λₚ₂) des Pumpenlichts bei der zweiten Temperatur (T₂) im Wesentlichen mit der Spitzenwellenlänge zusammenfällt oder länger als diese ist,
wobei die Länge der aktiven Faser (16) so ausgewählt ist, dass die Absorption des Pumpenlichts bei einer vorgegebenen Pumpenlichtwellenlänge im Gain-Medium der aktiven Faser (16) einen gewünschten Wert aufweist, der als eine Funktion der Länge der aktiven Faser bestimmt ist.

2. Verfahren nach Anspruch 2, wobei die Pumpenlichtwellenlänge aus der Gruppe ausgewählt ist, bestehend aus 8xx, 9xx und 106x nm.

3. Verfahren nach Anspruch 1, wobei das Gain-Medium Ionen beinhaltet, ausgewählt aus der Gruppe, bestehend aus Yb, Er, Tm und Nd und einer Kombination davon.

4. Faserlasersystem, umfassend:
mindestens einen Gain-Block (14), der mit einer aktiven Faser (16) eines Faserlaseroszillators (14) bereitgestellt ist; und
eine Pumpe, die zum Ausstrahlen eines Pumpenlichts geeignet ist, das in einem Gain-Medium der aktiven Faser (16) gekoppelt ist, wenn eine Temperatur von einer niedrigen Temperatur (T₁) zu einer hohen Temperatur (T₂) steigt,
wobei die Pumpe mit mindestens einer oder mehreren Laserdioden (12) konfiguriert ist, die jeweils das Pumpenlicht bei der niedrigen Temperatur (T₁) bei einer ersten Pumpenwellenlänge (λₚ₁) ausstrahlen, die kürzer als eine zweite Pumpenwellenlänge (λₚ₂) bei der hohen Temperatur (T₂) ist,
wobei das Gain-Medium der aktiven Faser (16) ein Absorptionsspektrum mit einer Spitzenwellenlänge aufweist, die Wellenlänge des Pumpenlichts, das bei der zweiten Pumpenwellenlänge (λₚ₂) emittiert wird, im Wesentlichen mit der Spitzenwellenlänge zusammenfällt oder ausgewählt ist, länger als die Spitzenwellenlänge zu sein und näher an der Spitzenwellenlänge ist als die erste Pumpenwellenlänge,
wobei die Länge der aktiven Faser (16) so ausgewählt ist, dass die Absorption des Pumpenlichts bei einer vorgegebenen Pumpenlichtwellenlänge im Gain-Medium der aktiven Faser (16) einen gewünschten Wert aufweist, der als eine Funktion der Länge der aktiven Faser bestimmt ist, sodass eine Ausgangsleistung und elektrooptische Effizienz des Faserlasersystems im Wesentlichen über den gesamten Temperaturbereich von der niedrigen Temperatur zur hohen Temperatur einheitlich bleibt, während eine Pumpenausgangsleistung während des Temperaturanstiegs abnimmt und Absorption des Pumpenlichts im Gain-Medium zunimmt, während die Temperatur ansteigt, wobei die zunehmende Absorption die abnehmende Pumpenleistung kompensiert.

5. System nach Anspruch 4, wobei die Pumpe Pumpenlicht bei einer Wellenlänge ausgibt, die aus der Gruppe ausgewählt ist, bestehend aus einem 8xx nm Bereich, 9xx nm Bereich und 106x nm Bereich.

6. System nach Anspruch 4, wobei das Gain-Medium Seltenerdionen beinhaltet, ausgewählt aus der Gruppe, bestehend aus Yb-, Er-, Tm- und Nd-Ionen und einer Kombination davon.

7. System nach Anspruch 4, wobei der Gain-Block weiter zwei passive Fasern beinhaltet, die direkt mit jeweils gegenüberliegenden Enden der aktiven Faser verschmolzen sind.

8. System nach Anspruch 7, weiter umfassend mindestens einen zusätzlichen Gain-Block und eine zusätzliche Pumpe, die im Wesentlichen identisch mit dem Gain-Block bzw. der Pumpe konfiguriert sind, wobei der eine und die zusätzlichen Gain-Blocks Laser- bzw. Faserverstärkerkonfigurationen aufweisen, die zwischen den niedrigen und hohen Temperaturen (T₁, T₂) arbeiten.

9. System nach Anspruch 7, wobei die aktiven und passiven Fasern jedes Gain-Blocks mit jeweiligen Kernen bereitgestellt sind, die konfiguriert sind, jeweilige Einzelmodi zu unterstützen, die im Wesentlichen einen einheitlichen Felddurchmesser aufweisen.

10. System nach Anspruch 9, wobei die aktive Faser eine MM-Faser ist, die konfiguriert ist, im Wesentlichen den Einzelmodus in einem Wellenlängenbereich des Ausgangs zwischen dem niedrigen und hohen Temperaturbereich zu unterstützen.

## Revendications

1. Procédé de stabilisation d'une puissance de sortie d'un système de laser à fibre (10) comprenant le couplage d'une lumière pompée provenant d'une pompe incluant une ou plusieurs diodes laser (12) dans une fibre active (16) d'un oscillateur de laser à fibre (14) entre une première température relativement basse (T₁) et une seconde température relativement élevée (T₂) en diminuant ainsi une puissance de pompage pendant l'élévation de température tout en augmentant l'absorption de la lumière pompée dans un milieu de gain de la fibre active lorsque la longueur d'onde pompée augmente pendant l'élévation de température, l'absorption croissante compensant la puissance pompée décroissante, de sorte que la puissance de sortie et l'efficacité électro-optique du système de laser restent substantiellement uniformes sur toute la plage de température de la première température à la seconde température,
la ou les diodes laser étant conçues pour que la longueur d'onde de lumière pompée plus longue (λₚ₂) à la seconde température relativement élevée (T₂) soit plus proche d'une crête de longueur d'onde du spectre d'absorption de milieu de gain à laquelle le milieu de gain absorbe la lumière pompée que la longueur d'onde plus courte (λₚ₁) de lumière pompée à la première température relativement basse (T₁) et que la longueur d'onde (λₚ₂) de la lumière pompée à la seconde température (T₂) coïncide substantiellement avec ou soit plus longue que la crête de longueur d'onde,
la longueur de la fibre active (16) étant sélectionnée de manière à ce que l'absorption de la lumière pompée à la longueur d'onde de lumière pompée prédéterminée dans le milieu de gain de la fibre active (16) ait une valeur souhaitée déterminée en fonction de la longueur de la fibre active.

2. Procédé selon la revendication 2, dans lequel la longueur d'onde de la lumière pompée est sélectionnée dans le groupe composé de 8xx, 9xx et 106x nm.

3. Procédé selon la revendication 1, dans lequel le milieu de gain inclut des ions sélectionnés dans le groupe composé de Yb, Er, Tm, et Nd et leurs combinaisons.

4. Système de laser à fibre comprenant :
au moins un bloc de gain (14) pourvu d'une fibre active (16) d'un oscillateur de laser à fibre (14) ; et
une pompe apte à irradier une lumière pompée couplée dans un milieu de gain de la fibre active (16) lorsqu'une température s'élève d'une basse température (T₁) jusqu'à une température élevée (T₂),
la pompe étant conçue avec au moins une ou plusieurs diodes laser (12) irradiant chacune la lumière pompée à la basse température (T₁) à une première longueur d'onde de pompage (λₚ₁) plus courte qu'une seconde longueur d'onde de pompage (λₚ₂) à la température élevée (T₂),
le milieu de gain de la fibre active (16) ayant un spectre d'absorption avec une crête de longueur d'onde, la longueur d'onde de la lumière pompée émise à la seconde longueur d'onde de pompage (λₚ₂) coïncidant substantiellement avec la crête de longueur d'onde ou étant sélectionnée pour être plus longue que la crête de longueur d'onde et étant plus proche de la crête de longueur d'onde que la première longueur d'onde de pompage,
la longueur de la fibre active (16) étant sélectionnée de manière à ce que l'absorption de la lumière pompée à la longueur d'onde de lumière pompée prédéterminée dans le milieu de gain de la fibre active (16) ait une valeur souhaitée déterminée en fonction de la longueur de la fibre active, de sorte qu'une puissance de sortie et une efficacité électro-optique du système de laser à fibre restent substantiellement uniforme sur toute la plage de température depuis la basse température jusqu'à la température élevée, alors qu'une puissance de sortie de pompe diminue pendant l'élévation de température et que l'absorption de la lumière pompée dans le milieu de gain augmente pendant l'élévation de température, l'absorption croissante compensant la puissance de pompe décroissante.

5. Système selon la revendication 4, dans lequel la pompe émet de la lumière pompée à une longueur d'onde sélectionnée dans le groupe composé d'une plage de 8xx nm, d'une plage de 9xx nm et d'une plage de 106x nm.

6. Système selon la revendication 4, dans lequel le milieu de gain inclut des ions de terres rares sélectionnés dans le groupe composé d'ions de Yb, Er, Tm et Nd et leurs combinaisons.

7. Système selon la revendication 4, dans lequel le bloc de gain inclut en outre deux fibres passives directement fusionnées dans des extrémités opposées de la fibre active.

8. Système selon la revendication 7, comprenant en outre au moins un bloc de gain supplémentaire et une pompe supplémentaire qui est conçue substantiellement de manière à être identique au bloc de gain et à la pompe respectifs, le bloc de gain et les blocs de gain supplémentaires ayant des configurations d'amplificateur de laser et de fibres fonctionnant entre les températures basses et élevées (T₁,T₂).

9. Système selon la revendication 7, dans lequel les fibres actives et passives de chaque bloc de gain sont pourvues de noyaux respectifs qui sont conçus pour être compatibles avec des modes uniques respectifs ayant substantiellement un diamètre de champ uniforme.

10. Système selon la revendication 9, dans lequel la fibre active est une fibre de MM conçue pour être compatible substantiellement avec le mode unique dans une plage de longueur d'onde de la sortie entre la plage des températures basses et élevées.
